## Europäisches Patentamt

## European Patent Office

## Office européen des brevets

(19)

(11) Numéro de publication: **0 024 243**
**B1**

(12) ## FASCICULE DE BREVET EUROPEEN

(45) Date de publication du fascicule du brevet:
07.03.84

(51) Int. Cl.³: **H 04 B 12/04**

(21) Numéro de dépôt: **80401172.4**

(22) Date de dépôt: **08.08.80**

(54) Dispositif pour réduire le débit numérique d'un signal MIC.

(30) Priorité: **10.08.79 FR 7920445**

(43) Date de publication de la demande:
**25.02.81 Bulletin 81/8**

(45) Mention de la délivrance du brevet:
**07.03.84 Bulletin 84/10**

(84) Etats contractants désignés:
**AT BE CH DE FR GB IT LI LU NL SE**

(56) Documents cités:
**FR - A - 2 166 220**

**IEEE 1974 INTERNATIONAL CONFERENCE ON COMMUNICATIONS, 17-19 juin 1974 Minneapolis New York US STROH: "Differential PCM with Adaptive Quantization for Voice Communications", pages 13C-1/13C-5
PROCEEDING OF THE IEE, vol. 123, no. 11, novembre 1976 Londres GB MARK: "Adaptive Predictive runlength encoding for analogue sources", pages 1189-1196
1974 International Zürich Seminar on Digital Communications. 12th-15th March 1974. M. Dietrich "Coding of Speech Signals using a switched Quantizer". pp.A4(1)-A4(4)**

(73) Titulaire: **SOCIETE ANONYME DE TELECOMMUNICATIONS, 40 avenue de New York, F-75116 Paris (FR)**

(72) Inventeur: **Cointot, Denis, 16 rue Larrey, F-75005 Paris (FR)**
Inventeur: **Langlois, Patrice, 8 avenue Galliéni, F-94100 Saint Maur (FR)**
Inventeur: **De Passoz, Guy, 19 rue du Grand Veneur, F-77330 Lesigny (FR)**

(74) Mandataire: **Bloch, Robert et al, Cabinet ROBERT BLOCH 39 avenue de Friedland, F-75008 Paris (FR)**

ACTORUM AG

## Dispositif pour réduire le débit numérique d'un signal MIC

La présente invention concerne la transmission numérique d'information codées en code MIC et plus particulièrement la réduction de débit numérique du signal transmis sur une ligne de transmission par un transcodage du type MIC - MIC Différentiel.

Le codage MIC est bien connu. Il consiste essentiellement à échantillonner le signal analogique à une fréquence dite d'échantillonnage et à quantifier selon une loi logarithmique les échantillons à raison de 8 éléments binaires par échantillon. Un tel code présente l'inconvénient de requérir un débit élevé pour la qualité exigée par l'utilisateur, car il n'exploite pas les propriétés statistiques du signal à transmettre.

Des systèmes de réduction de débit numérique ont déjà été décrits dans l'art antérieur. Ils permettent une compression du débit numérique en exploitant, pour la transmission d'un échantillon du signal, la connaissance acquise lors de la transmission des échantillons précédents.

Un système de ce type a été décrit dans l'article de M. DIETRICH, sur le séminaire international de Zurich, relatif aux communications numériques, du 12-14 mars 1974, paru dans Proceedings, IEEE, 1974. Ce dispositif consiste en un ensemble de trois étages montés en cascade dans lequel le premier étage appelé étage prédicteur permet de remplacer le signal MIC d'entrée par un signal $d_n$ représentant la différence entre le signal MIC d'entrée et la valeur prédite de cet échantillon, calculée à partir de l'échantillon précédent, un second étage dit de compression automatique de gain dans lequel l'amplitude du signal différence $d_n$ issu du premier étage est divisée par un estimateur de la puissance moyenne du signal. Un troisième étage appelé quantificateur à commutation effectue le codage optimum à partir des caractéristiques de quantification mises en mémoire qui s'adaptent le mieux aux distributions conditionnelles de probabilité du signal issu de l'étage précédent et fournit en sortie un signal numérique à redondance réduite formé de mots de longueur fixe égale à 4 éléments binaires par échantillon. Un dispositif équivalent en réception permet de reconstituer la trame MIC et de décoder le message.

Cependant un tel système, satisfaisant pour les signaux de parole appartenant à la bande de fréquence 300 - 3400 Hz échantillonnés à 8 kHz, ne s'applique pas aux autres signaux pouvant être transmis dans la bande de fréquence tels que des signaux de données, des signaux de télégraphie harmonique, ou encore des signaux de signalisation multi-fréquence, qui sont de statistiques différentes. On sait en effet que pour les signaux de parole le spectre présente un maximum au voisinage de 700 Hz mais pour des signaux de données ce spectre présente un maximum au voisinage de 2 kHz. Or l'étage prédicteur de M. DIETRICH qui est optimisé pour le spectre des signaux de parole n'est pas adapté aux autres types de signaux.

Cet étage prédicteur consiste en un filtre disposé sur une boucle de contre-réaction, et fournit un échantillon $x_{pn}$ prédit à partir de coefficients C (i) déterminés à partir de la fonction d'autocorrélation du signal à traiter. Cependant la prédiction ne sera optimale que pour un type donné de signaux et pour autant que ce signal soit stationnaire. Or le signal de parole n'est stationnaire qu'à court terme (environ 10 ms), ce qui implique de modifier les coefficients du prédicteur cent fois par seconde si l'on souhaite une prédiction toujours optimale. En outre un prédicteur fixe optimisé pour un signal de parole fournira une piètre prédiction pour un signal de données.

D'autres systèmes de réduction du débit numérique ont été conçus pour traiter des signaux de parole aussi bien que des signaux de données. De tels systèmes comportent généralement un prédicteur fixe dont les coefficients sont déterminés da façon à réaliser un compromis acceptable aussi bien pour les données que pour la parole.

Cependant ces systèmes fournissent une qualité de transmission qui est insuffisante pour permettre leur introduction dans les réseaux commerciaux de télécommunications.

L'invention vise à procurer un dispositif de réduction du débit numérique capable de traiter des signaux numériques MIC de tous types.

L'invention a pour objet un dispositif pour réduire le débit numérique d'un signal MIC S formé d'échantillons $x_n$ de période T, comprenant trois étages montés en cascade, à savoir un premier étage dit de prédiction dans lequel on soustrait d'un échantillon $x_n$ un signal prédit $x_{pn}$ déduit des échantillons précédents pour former un signal de différence $d_n$, un second étage dit de compression automatique de gain dans lequel on divise l'amplitude du signal de différence $d_n$ pour obtenir un signal de différence divisé $e_n$, et un troisième étage dit quantificateur dans lequel on code le signal de différence divisé $e_n$ de façon à obtenir un signal de différence divisé et codé $Y_n$ de débit réduit par rapport au signal S, des moyens multiplicateurs et décodeurs étant prévus dans les second et troisième étages pour former un signal de différence $\hat{d}_n$ reconstitué à partir du signal de différence divisé et codé $Y_n$, le premier étage comprenant, pour la détermination des signaux prédits, un additionneur 10 recevant le signal prédit $x_{pn}$ et le signal $\hat{d}_n$, le signal de sortie de l'additionneur 10 étant appliqué à une série de multiplicateurs $M_1...M_N$ effectuant le produit par des coefficients respectifs $a_i$ (n) $(1 \leqslant i \leqslant N)$ déduits des échantillons n-i précédents selon un algorithme exploitant le critère du minimum de l'erreur quadratique, les multiplicateurs $M_2...M_N$ étant respectivement connectés à l'additionneur 10 par des lignes à retard $(T_2...T_N)$ imposant respectivement des retards 2T...NT, les produits obtenus à la sortie des multiplicateurs étant appliqués à un additionneur 11, une ligne à retard $T_1$ fournissant un retard T étant montée à la sortie de l'additionneur 10 ou en amont du multiplicateur $M_1$, le signal obtenu étant le signal prédit $x_{pn}$ qui sera retranché de l'échantillon $x_n$, caractérisé par le fait que l'étage quantificateur comprend des moyens de sélection (6) auxquels sont appliqués les coefficients $a_i$ (n) et comparant au moins un de ces coefficients à une valeur prédéterminée, pour déterminer les propriétés statistiques du signal S, et adapter ainsi le type de codage aux propriétés statistiques du signal S.

Selon une autre caractéristique de l'invention, chaque coefficient $a_i$ (n) est obtenu en formant la somme du coefficient $a_i$ (n—1) calculé lors de la période précédente et du produit du signal respectivement appliqué au multiplicateur $M_i$ par le signal de différence $\hat{d}_n$ reconstitué et par une constante $\alpha$, en multipliant cette somme par une constante $1-\beta$ et en ajoutant au produit obtenu le produit du facteur $\beta$ par un coefficient $a_{oi}$ (n—1) choisi lors de la période précédente parmi une pluralité de valeurs en fonction de la statistique du signal entrant.

De façon préférée, les coefficients $a_i$ sont, avant d'être appliqués, transformés en coefficients $a_i^*$ par un traitement consistant à comparer chaque coefficient avec les bords d'un domaine borné et à substituer à tout coefficient extérieur à ce domaine la valeur la plus proche sur la frontière du domaine.

D'autres avantages et caractéristiques apparaîtront à la lecture de la description suivante illustrée par des dessins.

La figure 1 est une représentation schématique générale de la partie émission d'un système de réduction de débit numérique à réduction de redondance.

La figure 2 est une représentation détaillée d'un mode de réalisation préféré de la figure 1, dans le cas de N coefficients.

La figure 3 est une représentation générale, i étant quelconque, du dispositif 9 de réactualisation du coefficient $a_i$.

La figure 4 est une représentation possible du domaine d'évolution des coefficients $a_1$ et $a_2$ du prédicteur adaptatif de la figure 2 pour laquelle N = 2.

La figure 5 illustre la sélection du vecteur $A_o$ dans le cas de réalisation de la figure 4 pour lequel N = 2.

La figure 6 montre une réalisation préférée du dispositif de la figure 2 dans le cas où N = 2.

La figure 7 représente schématiquement la partie réception du système selon l'invention.

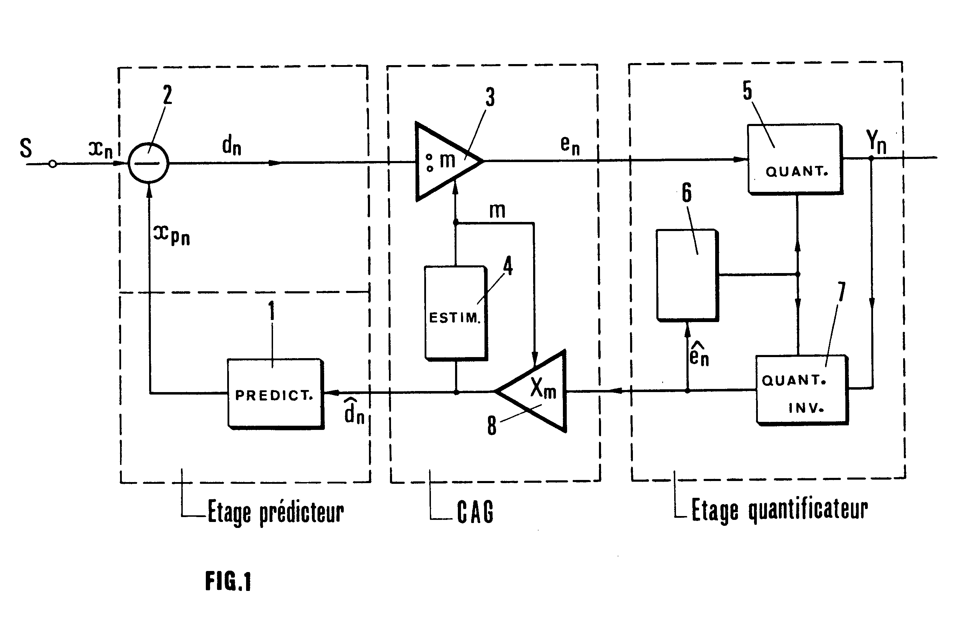

En se référant à la figure 1 le signal S entrant est un signal MIC résultant du codage de signaux de parole, de données ou de signalisation multifréquence et se présente sous la forme d'une trame de multiplexage MIC composée d'échantillons $x_n$. De chaque échantillon $x_n$ on retranche un échantillon prédit $x_{pn}$ fourni par un prédicteur 1 au moyen d'un circuit de soustraction 2 qui fournit en sortie des échantillons $d_n$ représentatifs de la différence entre la valeur de l'échantillon entrant $x_n$ et de l'échantillon prédit $x_{pn}$ fourni par ce prédicteur 1. Cet étage prédicteur sera plus amplement décrit au moyen des figures suivantes. Il permet principalement de remplacer le signal MIC S d'entrée par un signal différence $d_n$ dont la variance est plus faible de manière à réduire le nombre d'échelons de quantification à qualité équivalente.

Le signal différence $d_n$ est appliqué à l'entrée d'un étage de compression automatique (CAG) dans lequel l'amplitude du signal différence $d_n$ est divisée par m au moyen d'un diviseur 3, la grandeur m étant fournie par un estimateur 4 de la puissance moyenne afin d'augmenter la dynamique du codeur.

Le troisième étage dit étage quantificateur, monté en cascade avec le précédent reçoit le signal $e_n$ issu du diviseur 3, tel que $d_n = me_n$ et effectue le codage de l'information $e_n$ à partir des caractéristiques de quantification qui s'adaptent le mieux à la statistique du signal issu de l'étage CAG. Il se compose essentiellement d'un quantificateur 5 permettant de transformer les échantillons $e_n$ à grand débit en une suite d'échantillons $Y_n$ à faible débit en fonction de la statistique du signal $e_n$ à quantifier. Le choix de la courbe de quantification en fonction de la nature du signal à traiter, signal de données ou signal de parole, est effectué par un dispositif 6 qui reçoit le signal $\hat{e}_n$ reconstitué par un quantificateur inverse 7. Le quantificateur inverse 7 disposé sur une boucle à contre-réaction reçoit à son entrée le signal $Y_n$ transcodé par le quantificateur 5 et fournit à sa sortie un signal $\hat{e}_n$ qui est identique à celui qui est obtenu en réception en l'absence d'erreurs de transmission. Le signal $\hat{e}_n$ est appliqué à l'entrée d'un circuit 8 multiplicateur par m, qui fournit à sa sortie la grandeur $\hat{d}_n = m\hat{e}_n$ de la différence reconstituée. Cette grandeur $\hat{d}_n$ est appliquée d'une part au prédicteur 1 de l'étage prédicteur, d'autre part à l'estimateur de puissance moyenne 4.

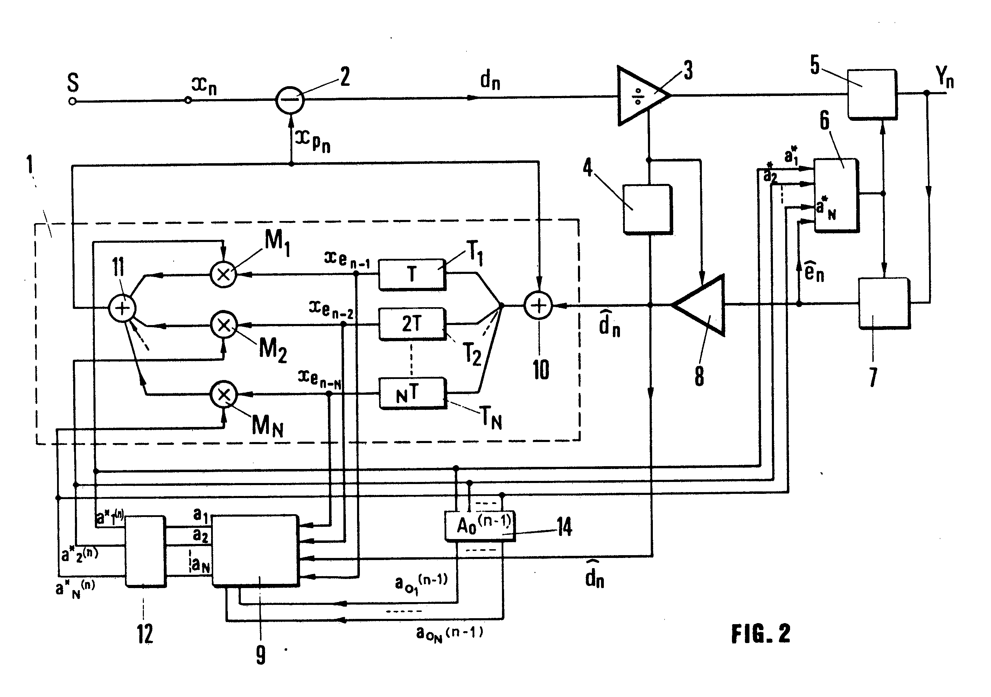

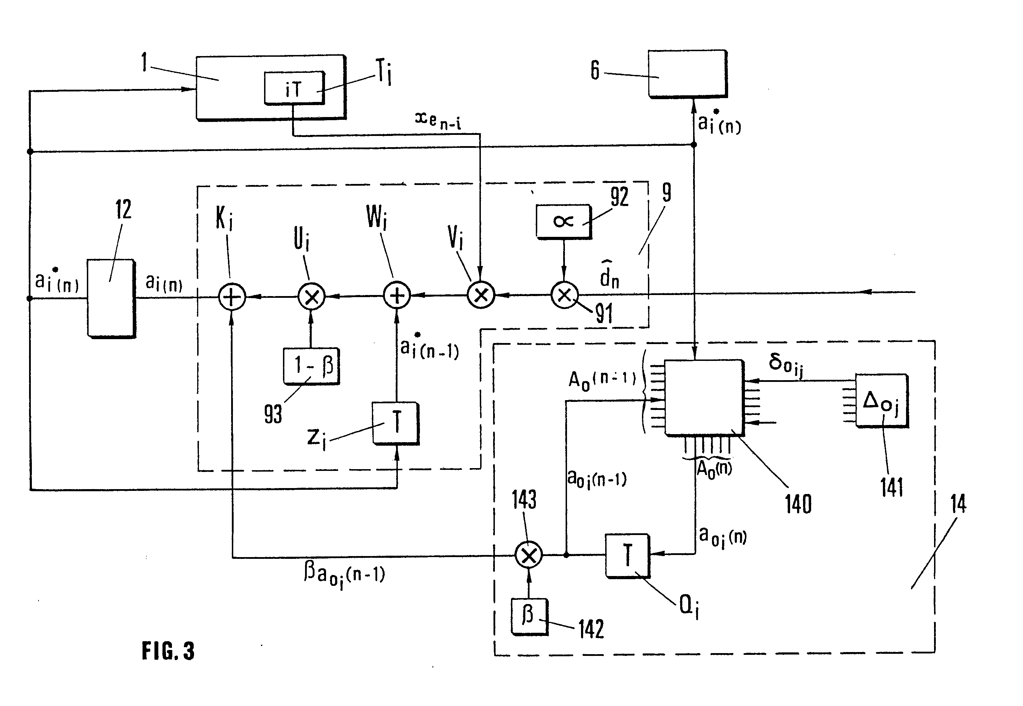

En se référant à la figure 2 le prédicteur 1 se compose d'un circuit additionneur 10 qui reçoit d'une part le signal différence $\hat{d}_n$ reconstituée fournie par l'étage de compression CAG de la boucle de contre-réaction et d'autre part la grandeur $x_{pn}$ prédite de l'échantillon n. Ce circuit additionneur 10 fournit la somme ainsi calculée pour chaque échantillon à N mémoires $T_1$, $T_2$...$T_N$ réalisant respectivement un retard d'une période T d'échantillonnage, un retard de deux périodes d'échantillonnage... jusqu'à un retard de N périodes d'échantillonnage. La grandeur N est comprise avantageusement entre 2 et 8. Les grandeurs $xe_{n-1}$,...$xe_{n-N}$ obtenues à la sortie des N mémoires $T_1$...$T_N$ sont multipliées par N coefficients $a_1$...$a_N$ respectivement au moyen de N circuits multiplicateurs $M_1$...$M_N$. Les coefficients $a_1$, $a_2$...$a_N$ sont fournis par un dispositif 9 qui réactualise les coefficients à chaque période d'échantillonage selon le critère du minimum de l'erreur quadratique moyenne. Le dispositif 9 sera ultérieurement décrit à l'aide de la figure 3. Les grandeurs fournies par les N circuits multiplicateurs $M_1$, $M_2$...$M_N$ sont additionnées au moyen d'un circuit additionneur 11 qui fournit en sortie la valeur $x_{pn}$ prédite de l'échantillon $x_n$.

La grandeur $x_{pn}$ prédite est appliquée d'une part à l'entrée du circuit soustracteur 2 pour fournir en sortie la grandeur $d_n$ différence et d'autre part à l'entrée du circuit additionneur 10 ainsi qu'il a été précédemment expliqué.

Le dispositif 9 fournissant les coefficients $a_1$, $a_2$...$a_N$ permet au prédicteur 1 de réactualiser la valeur prédite de chaque échantillon $x_{pn}$. Le vecteur A (n + 1) des coefficients est obtenu selon l'invention de façon avantageuse au moyen de la formule récursive suivante ou algorithme de calcul des coefficients.

$$A (n+1) = (1 - \beta) [A (n) + \alpha \hat{d}_n \times E_n] + \beta A_o (n)$$

dans laquelle
  $\alpha$, $\beta$ sont des constantes.
  $\alpha$ est le pas de l'algorithme, et
  $\beta$ est un terme de fuite destiné à parmettre l'alignement des paramètres du récepteur sur ceux de l'émetteur en cas de divergence à la suite d'erreurs de
transmission.

$A_o$ (n) détermine la valeur asymptotique du vecteur A (n) en l'absence de signal à l'entrée du système. Lorsque le signal d'entrée S est différent de O,
$A_o$ (n) peut prendre différentes valeurs en fonction
de celle de A (n), c'est-à-dire en fonction de la statistique du signal à traiter, ainsi qu'il sera expliqué ultérieurement.

Le dispositif de la figure 2 reçoit donc les grandeurs
$xe_{n-1}$, $xe_{n-2}$...$xe_{n-N}$ fournies par les mémoires $T_1$,
$T_2$...$T_N$ ainsi que la grandeur $\hat{d}_n$ fournie par l'étage
CAG à la sortie de (8).

Ainsi le dispositif 9 est formé de N circuits semblables, chacun fournissant un coefficient $a_i$ ($1 \leqslant i \leqslant N$)

$$a_i (n+1) = [a_i (n) + \alpha \hat{d}_n xe (n-i)] (1 - \beta) + \beta a_{oi} (n)$$

La figure 3 représente le ième circuit formant le dispositif 9. Il consiste essentiellement en un circuit
multiplicateur 91 recevant la constante $\alpha$, fournie par
une mémoire 92 ainsi que la grandeur $\hat{d}_n$ reconstituée fournie par le dispositif 8 de l'étage CAG.

La grandeur $\alpha \hat{d}_n$ est multipliée avec $xe_{n-i}$ au moyen d'un circuit de multiplication $V_i$. Cette grandeur
$xe_{n-i}$ est fournie à la sortie du régistre $T_i$ du prédicteur 1. On additionne ensuite le résultat obtenu à la
sortie du circuit de multiplication $V_i$ avec la grandeur
$a_i^* (n-1)$ contenue dans une mémoire $Z_i$, au moyen
d'un circuit d'addition $W_i$. Le résultat obtenu à la
sortie du circuit d'addition $W_i$ est multiplié avec le
facteur $(1 - \beta)$ contenu dans une mémoire 93 au moyen d'un circuit de multiplication $U_i$, le résultat de ladite multiplication étant ensuite additionné au moyen
d'un circuit d'addition $K_i$ avec la ième composante
$a_{oi} (n-1)$ du vecteur $A_{oi} (n-1)$ préalablement multipliée par le coefficient $\beta$ de fuite. Cette grandeur $\beta$
$a_{oi} (n-1)$ est fournie par un dispositif 14. Le résultat
de l'addition fourni par le circuit $K_i$ est le coefficient
$a_i (n)$.

Les N coefficients $a_i (n)$ issus du dispositif 9 sont
avantageusement appliqués selon l'invention à l'entrée d'un comparateur 12 avant d'être fournis au prédicteur 1. En effet le domaine de stabilité intrinsèque
du prédicteur 1 est un domaine limité, borné par les
valeurs $a_1$, $a_2$...$a_i$...$a_N$ des coefficients et détermine
le taux de décroissance d'une erreur ponctuelle de
transmission.

Si le signal reçu $\hat{d}'_n$ résulte de la superposition du
signal vrai $\hat{d}_n$ transmis et d'une impulsion $\epsilon$ d'erreur,
il est nécessaire que le prédicteur placé en réception
ne soit pas perturbé au-delà de certaines limites.

On alloue de ce fait aux coefficients un domaine
d'évolution apportant au prédicteur une stabilité intrinsèque. On se fixe arbitrairement un taux de décroissance de l'erreur $\epsilon$ (approximativement la réponse impulsionnelle est inférieure à 10% de sa valeurinitiale après 40 périodes d'échantillonnage).

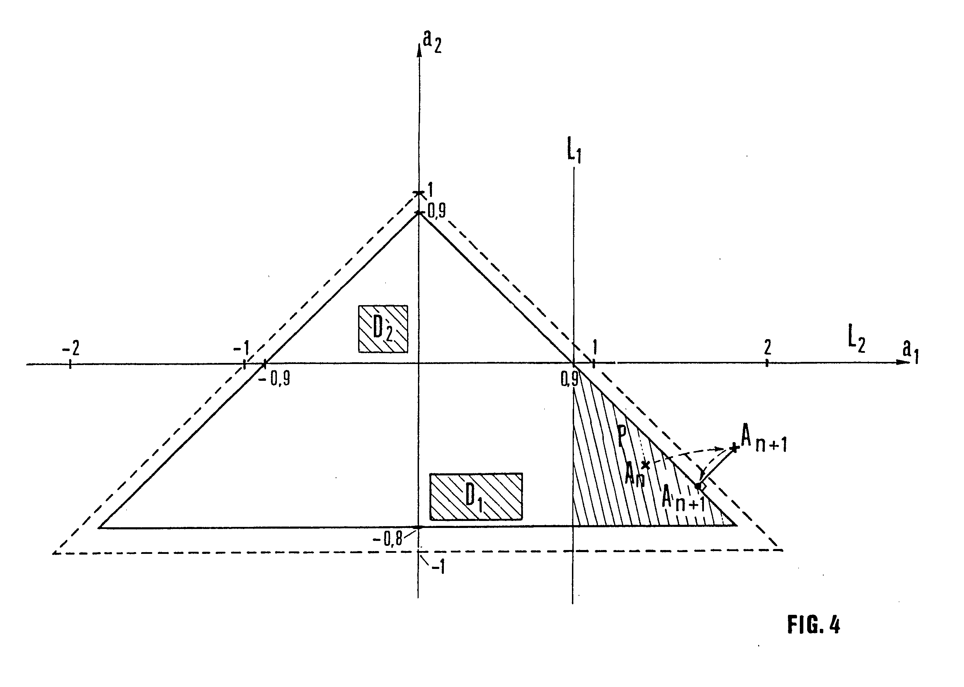

La figure 4 illustre en pointillé le domaine de stabilité
des coefficients dans le cas où N = 2. Le triangle intérieur

$$|a_1| + a_2 < 0,9$$
$$a_2 > -0,8$$

délimite le domaine de convergence rapide à l'intérieur duquel les coefficients $a_1$ et $a_2$ ne perturberont
pas la transmission en cas d'erreur ponctuelle. Ainsi
supposons que le vecteur A (n + 1) fourni par le dispositif 9 soit extérieur au triangle de stabilité, on le corrige au moyen du dispositif 12 pour le ramener sur le
bord du triangle de stabilité. Le dispositif 12 est un
comparateur qui compare chacun des coefficients
$a_1 (n+1)$ et $a_2 (n+1)$ avec les coefficients $a_1^* (n+1)$
et $a_2^* (n+1)$ du point le plus proche situé sur le triangle. Le dispositif 12 transmet donc:

$$a_1^* (n+1) \text{ et } a_2^* (n+1)$$

$$a_1^* (n+1) = [\text{signe } a_1 (n+1)] \times \min [|a_1 (n+1)|,$$
$$\frac{|a_1 (n+1)| - a_2 (n+1) + 0,9}{2} , (1,7)]$$

$$a_2^* (n+1) = \max [-(0,8), \min \{a_2 (n+1),$$
$$\frac{a_2 (n+1) - |a_1 (n+1)| + 0,9\}}{2}$$

En outre la localisation des coefficients dans le domaine de stabilité permet de reconnaître la nature du
signal S d'entrée (par exemple signal de parole ou
signal de données). En effet la distribution statistique
du vecteur {A (n)} des coefficients d'un signal de parole décrit un domaine P qui est, par exemple, délimité
par la droite $L_1$ telle que $a_1 \geqslant 0,9$ et $a_2 < 0$.

Par contre la répartition statistique habituelle des
signaux de données est telle que $a_1 < 0,9$. Certains
signaux de données $D_1$ sont tels que $a_1 < 0,7$ et $a_2$
$< 0$. On peut envisager d'autres signaux de données
$D_2$ tels que $a_1 < 0, a_2 > 0$. Ainsi les divers types de
signaux possibles pouvant être présents à l'entrée
correspondent à des vecteurs de coefficients A (n) à
la sortie du dispositif 9 situés à l'intérieur du domaine
de stabilité mais dans des secteurs ne se recoupant
pas.

La détermination de la position de chaque vecteur
$A^* (n)$ de coefficient, après correction au moyen du
comparateur 12, est utilisée selon l'invention dans le
choix de la caractéristique de quantification fournie
par l'étage quantificateur (5, 6, 7). Le dispositif 5
contient en mémoire diverses caractéristiques de
quantification aussi bien pour les signaux de parole
que pour les signaux de données. Les systèmes
quantificateurs à commutation de l'art antérieur traitaient uniquement des signaux de parole, au moyen
de la grandeur $\hat{e}_n$ fournie par le quantificateur inverse 7, et la détermination de la courbe de quantification appropriée était faite uniquement à partir de la
grandeur $\hat{e}_n$ fournie par le dispositif 7.

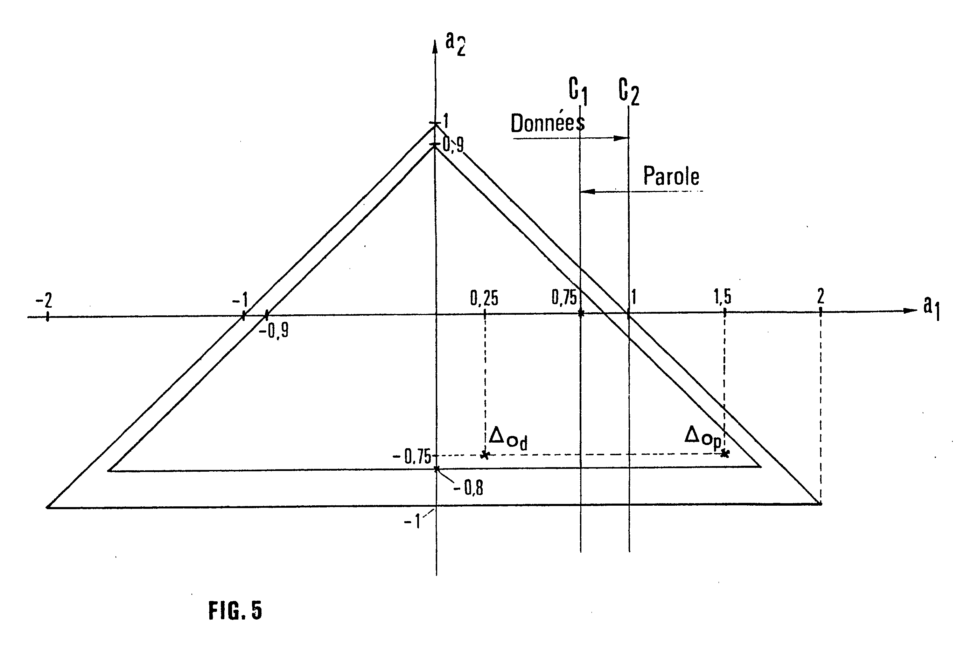

Selon l'invention, le critère de décision n'est plus
uniquement fourni par $\hat{e}_n$ mais aussi par la connaissance de $A_i^* (n+1)$ qui détermine de façon non équivoque s'il s'agit d'un signal de parole P, d'un signal
de données $D_1$ ou de données $D_2$ etc... La connaissance de $A_i^* (n+1)$ confère au dispositif 6 le rôle de
sélecteur de la courbe de quantifications mémorisée
dans l'un des dispositifs 5 ou 7 de l'étage quantificateur selon qu'il s'agit de la transformation directe ou
inverse. En reprenant le cas de la figure 4, où N = 2, il
suffira de déterminer $a_1^*$ pour savoir s'il s'agit d'un signal de parole ou d'un signal de données: si $a_1^* >$ 0,9 il s'agit d'un signal de parole et si $a_1^* < 0,9$ il s'agit d'un signal de données. Cet exemple de réalisation sera illustré au moyen de la figure 5, pour lequel le choix de la catégorie de caractéristiques de quantification (parole ou données) est donné par la connaissance de $a_1^*$. Un tel choix permet d'avoir une courbe de quantification toujours adaptée, d'avoir un rapport signal sur bruit meilleur et donc d'avoir une meilleure qualité à débit égal.

Le dispositif de prédiction des coefficients selon l'invention fait en outre intervenir les coefficients $a_{oi}$ (n) du vecteur $A_o$ (n), valeur asymptotique du vecteur A (n) en l'absence de signal à l'entrée. En se référant à la figure 2, on dispose selon l'invention un dispositif de sélection 14 des coefficients $A_o$ (n) permettant de choisir des coefficients $A_o$ (n) adaptés à la statistique du signal à traiter. Ce dispositif 14 est essentiellement formé d'une mémoire 141 contenant k vecteurs $\Delta_{oj}$ de N composantes et d'un comparateur qui compare le vecteur $A_o$ (n—1) précédemment utilisé ainsi que le vecteur des coefficients $A^*$ (n) fourni par le dispositif 12 aux différents vecteurs $\Delta_{oj}$ convenablement choisis en fonction de la statistique du signal à traiter (données, parole).

Ce dispositif 14 est illustré sur la figure 3 qui représente le traitement de la ième composante du vecteur $A^*$ (n). Le coefficient $a_i^*$ (n) est appliqué à l'entrée d'un comparateur 140 qui reçoit la composante $\delta_{oij}$ du vecteur $\Delta_{oj}$ contenu dans la mémoire 141. Le comparateur 140 reçoit également la composante $a_{oi}$ (n—1) fournie par un registre $Q_i$ à décalage qui retarde d'un temps T la grandeur $a_{oi}$ (n) fournie à la sortie du comparateur 140. Le comparateur 140 fournit à sa sortie la grandeur $\delta_{oij}$ la mieux adaptée, sachant que $a_{oi}$ (n—1) et $a_i^*$ (n) ont — ou n'ont pas — une valeur caractéristique des données ou de la parole. Le coefficient $a_{oi}$ (n—1) fourni par le registre $Q_i$ est multiplié par $\beta$ contenu dans la mémoire 142 grâce au circuit de multiplication 143 puis appliqué à l'entrée du circuit d'addition $K_i$ pour y être additionné avec la grandeur fournie par le circuit de multiplication $U_i$ du dispositif 9.

Dans la pratique on peut se limiter à j égal à 2. En effet on distinguera $\delta_{op}$ et $\delta_{od}$ selon qu'il s'agit d'un signal de parole ou de données.

Ainsi le fait d'avoir en mémoire plusieurs valeurs $\Delta_j$ possibles pour $A_o$ (n) permet d'adopter une valeur de la fuite $\beta$ assez importante sans avoir une valeur trop grande pour la constante $\alpha$ et donc d'autoriser une bonne résistance de l'algorithme aux erreurs de transmission tout en conservant une bonne adaptation du prédicteur.

La figure 5 appliquée au cas N = 2 permet de situer concrètement le choix des coefficients $A_o$ (n) comme pour le choix des coefficients $A^*$ (n + 1) par rapport aux coefficients $A^*$ (n), dans le domaine de stabilité on peut se borner à reconnaître la position de $a_1^*$ (n) par rapport à deux valeurs $\delta_{op}$ et $\delta_{od}$ de référence pour savoir quelle valeur $a_o$ (n) sera choisie. En effet on trace les droites $C_1$ telle que $a_1 = 0,75$ et $C_2$ telle que $a_1 = 1$ et connaissant $a_{o1}$ (n—1) et $a_1^*$ (n) on adopte une valeur $a_{o1}$ (n) égale à l'une des deux valeurs $\delta_{op}$ ou $\delta_{od}$ selon que l'on se trouve dans un secteur ou dans l'autre du domaine de stabilité.

Lorsque $a_1^*$ devient inférieur à 1, on présume qu'il s'agit d'un signal de données et lorsque $a_1^*$ devient supérieur à 0,75 on présume qu'il s'agit d'un signal de parole.

Le secteur du triangle de stabilité des coefficients compris entre les droites $C_1$ et $C_2$ permet également de déterminer $a_{o1}$ (n) grâce à la connaissance de $a_{o1}$ (n—1).

Le tableau suivant résume les différentes possibilités pour le choix de $a_{o1}$ (n) en fonction des coefficients $a_1^*$ (n) et $a_{o1}$ (n—1):

| $a_{o1}(n-1)$ | $\delta_{op}$ | $\delta_{od}$ | $\delta_{op}$ | $\delta_{od}$ |
|---|---|---|---|---|
| $a_1^*(n)$ | $> 0,75$ | $< 1$ | $\leqslant 0,75$ | $\geqslant 1$ |
| $a_{o1}(n)$ | $\delta_{op}$ | $\delta_{od}$ | $\delta_{od}$ | $\delta_{op}$ |

Un tel choix confère au système une stabilité supplémentaire vis-à-vis des erreurs et une meilleure adaptation à la statistique du signal à traiter.

Dans cet exemple on a choisi la grandeur $a_{o2}$ (n) égale à $-0,75$ quel que soit n mais il serait également possible de réactualiser $a_{o2}$ (n) à chaque instant.

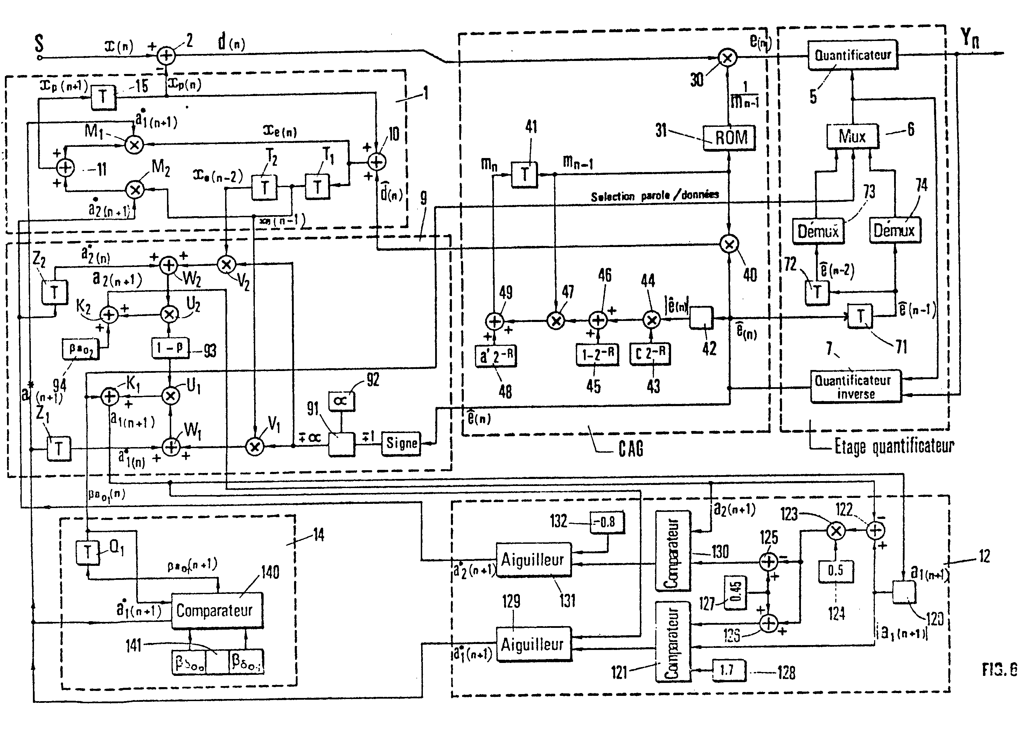

La figure 6 représente un mode de réalisation préféré de l'invention dans le cas où N = 2. Le prédicteur 1 se compose du circuit d'addition 10, des registres $T_1$ et $T_2$, des circuits de multiplication $M_1$ et $M_2$ et enfin du circuit d'addition 11. Dans cet exemple de réalisation le circuit de multiplication $M_1$ reçoit directement le coefficient $xe_n$ non retardé tandis que le circuit de multiplication $M_2$ reçoit le coefficient $xe_{n-1}$ fourni par le registre $T_1$. En compensation un registre 15 disposé à la sortie du circuit d'addition 11 retarde le coefficient $x_p$ (n + 1) d'un temps T et fournit ainsi le coefficient $x_p$ (n) à l'entrée du circuit d'addition 2.

Le dispositif 9 qui calcule les coefficients $a_1$ (n) et $a_2$ (n) reçoit le signe de la grandeur $\hat{e}_n$ décodée fournie par le quantificateur inverse 7 et la multiplie au moyen du circuit 91 de multiplication avec la constante $\alpha$ contenue dans la mémoire 92. Il suffit en effet que le dispositif 9 connaisse le signe de $\hat{e}_n$ pour le calcul des coefficients.

Les deux circuits de multiplication $V_1$ et $V_2$ multiplient le signe de $\hat{e}_n$ respectivement avec $xe_{n-1}$ et $xe_{n-2}$ issus des registres $T_1$ et $T_2$ du prédicteur 1 et fournissent des facteurs qui sont ensuite respectivement additionnés aux grandeurs $a_1^*$ (n) et $a_2^*$ (n) précédemment obtenus et contenus dans les mémoires $Z_1$ et $Z_2$. Les résultats fournis par les circuits d'addition $W_1$ et $W_2$ sont ensuite multipliés respectivement par 1-$\beta$ contenu dans une mémoire 93 au moyen des circuits de multiplication $U_1$ et $U_2$. Les résultats fournis par les circuits de multiplication $U_1$ et $U_2$ sont ensuite additionnés avec les valeurs $\beta a_{o1}$ (n) et $\beta a_{o2}$ (n) respectivement au moyen des circuits d'addition $K_1$ et $K_2$. Les valeurs $\beta a_{o1}$ (n) et $\beta a_{o2}$ (n) sont respectivement contenues dans les mémoires $Q_1$ et 94. A la sortie des circuits d'addition $K_1$ et $K_2$ on obtient respectivement $a_1$ (n + 1) et $a_2$ (n + 1) qui sont appliqués à l'entrée du circuit 12 de comparaison.

Le coefficient $a_1$ (n + 1) fourni par le circuit $K_1$ d'addition est transformé en un coefficient positif $|a_1$ (n + 1)$|$ an moyen d'un circuit 120. Ce coeffi-

cient $|a_1 (n+1)|$ est ensuite d'une part appliqué à l'entrée d'un comparateur 121, d'autre part soustrait au coefficient $a_2 (n+1)$ au moyen du circuit soustracteur 122. Le résultat de la soustraction effectuée par 122 est multiplié par la constante 0,5, extraite de la mémoire 124, au moyen d'un circuit de multiplication 123, ledit résultat étant appliqué à l'entrée de deux circuits d'addition 126 et 125 avec des signes opposés. Le circuit d'addition 126 additionne le résultat obtenu en sortie du circuit 123 avec une constante 0,45 contenue dans une mémoire 127.

Le résultat de l'addition obtenu en sortie du circuit 126 est appliqué à l'entrée du comparateur 121 qui reçoit également la constante 1,7 fournie par la mémoire 128 et la grandeur $|a_1 (n+1)|$ fournie par le circuit 120.

Le résultat de la comparaison, plus exactement le minimum de ces trois grandeurs, est appliqué à l'entrée d'un dispositif aiguilleur 129 qui reçoit à son entrée également le coefficient $a_1 (n+1)$ fourni par le circuit $K_1$ du dispositif 9. On obtient à la sortie du dispositif aiguilleur 129 un coefficient $a_1^* (n+1)$ qui a pour signe le signe de $a_1 (n+1)$ et pour grandeur le minimum de

$|a_1 (n+1)|$, de $\dfrac{|a_1 (n+1) - a_2 (n+1) + 0,9|}{2}$ et de

1,7 et ce afin de rester dans le domaine de stabilité.

De la même façon un comparateur 130 reçoit d'une part le coefficient $a_2 (n+1)$ et d'autre part le résultat de la soustraction de la constante 0,45 fournie par la mémoire 127 et de la grandeur fournie par le circuit de multiplication 123, ladite soustraction étant effectuée par le circuit 125. Le résultat de la comparaison, le minimum plus exactement, effectué par le comparateur 130 est appliqué à l'entrée d'un circuit aiguilleur 131 qui reçoit également la grandeur $- 0,8$ fournie par la mémoire 132 et fournit à sa sortie le coefficient $a_2^* (n+1)$ qui représente effectivement le maximum entre la grandeur $- 0,8$ et la grandeur

$\min [a_2 (n+1), \dfrac{a_2 (n+1) - |a_1 (n+1)| + 0,9}{2}]$.

Les coefficients $a_1^* (n+1)$ et $a_2^* (n+1)$, ainsi éventuellement corrigés pour rester dans le triangle de stabilité, sont appliqués à l'entrée des mémoires $Z_1$ et $Z_2$ respectivement du dispositif 9. Les mémoires $Z_1$ et $Z_2$ sont en fait des lignes à retard qui fournissent les résultats au bout d'un temps T, égal à la période d'échantillonnage, à leur sortie afin d'être utilisés pour l'échantillon suivant dans le calcul de $x_p (n+1)$.

Le coefficient $a_1^* (n+1)$ issu du dispositif aiguilleur 129 est également appliqué à l'entrée d'un dispositif 14 de comparaison qui compare $a_1^* (n+1)$ à des grandeurs numériques $\beta \delta_{op}$ et $\beta \delta_{od}$ contenues dans une mémoire 141. Les coefficients $\beta a_o (n)$ précédemment calculés et contenus dans la mémoire $Q_1$ (qui est en fait un registre à décalage retardant d'un temps T) sont également appliqués à l'entrée du comparateur 140 pour être comparés aux deux grandeurs $\beta \delta_{op}$ et $\beta \delta_{od}$.

Ce comparateur 140 fournit à sa sortie un coefficient $\beta a_{o1} (n+1)$ conformément aux critères de sélection explicités à l'aide de la figure 4. Le coefficient $a_{o1} (n)$ est ensuite, d'une part, appliqué à l'entrée du circuit d'addition $K_1$ et, d'autre part, utilisé par l'étage de quantification.

Le coefficient $a_1^* (n)$ est usuellement appliqué à l'entrée d'un dispositif 6 de choix de la caractéristique de quantification de l'étage de quantification. Mais on applique, selon le dispositif de la figure 6, le coefficient $a_{o1} (n)$ à l'entrée du dispositif 6 sans changer le principe de l'invention. En effet $a_1^* (n)$ intervient dans le calcul de $a_{o1} (n)$.

Le dispositif 6, qui en fait est un multiplexeur, reçoit les informations $\hat{e} (n-2)$ et $\hat{e} (n-1)$ fournies par deux démultiplexeurs 73 et 74. Le démultiplexeur 74 reçoit l'information $\hat{e} (n-1)$ fournie par le quantificateur inverse 7 et retardée au moyen de la ligne à retard 71. Le démultiplexeur 73 reçoit l'information $\hat{e} (n-2)$ issue de la ligne à retard 71 et retardée à nouveau d'un temps T dans la ligne à retard 72. Le multiplexeur 6 fournit en sortie les adresses permettant de quantifier le signal $e_n$ de façon appropriée dans le quantificateur 5 selon que le signal est de données ou de parole. Le quantificateur 5 peut contenir en mémoire différentes courbes de quantification pour chaque type de signal: (données $D_1$, données $D_2$, parole P... etc...). C'est le multiplexeur 6 qui fournit les adresses, d'une part, au quantificateur 5 et, d'autre part, au quantificateur inverse 7 placé sur la boucle de contre-réaction, pour lui permettre de décoder les $Y_n$ sortants.

La grandeur $\hat{e}_n$ décodée fournie par le quantificateur inverse 7 de l'étage quantificateur est également appliquée à l'entrée d'un dispositif CAG qui fournit en sortie la valeur $m_n$ du taux de compression correspondant à l'échantillon n. Ce dispositif CAG est essentiellement formé d'un premier circuit 42 fournissant à sa sortie la valeur absolue $|\hat{e}_n|$. Cette grandeur est ensuite multipliée avec la constante C $2^{-R}$ contenue dans la mémoire 43 au moyen du circuit de multiplication 44. Ce résultat obtenu à la sortie du circuit 44 est additionné avec la constante $(1 - 2^{-R})$ contenue dans la mémoire 45 au moyen d'un circuit d'addition 46. Le résultat obtenu à la sortie du circuit 46 est multiplié avec la grandeur $m_n$ de l'échantillon précédent fournie par la mémoire 41 au moyen du circuit de multiplication 47. Le résultat obtenu à la sortie du circuit 47 est additionné avec une constante a' $2^{-R}$ contenue dans la mémoire 48 au moyen du circuit d'addition 49. A la sortie du circuit 49 on obtient $m_n$ qui est appliqué à l'entrée de la mémoire 41 afin d'être disponible la période suivante. La grandeur $m_{n-1}$ fournie par le registre 41 est introduite dans une mémoire 31 dans laquelle elle est inversée en $1/m_{n-1}$.

La grandeur $m_{n-1}$ fournie par la mémoire 41 et la grandeur $\hat{e} (n)$ fournie par le quantificateur inverse 7 sont multipliées au moyen du circuit 40 de multiplication et le résultat $\hat{d} (n)$ de ladite multiplication est appliqué à l'entrée du circuit d'addition 10 avec la grandeur $x_{pn}$ calculée par le système prédicteur de l'invention pour l'échantillon précédent.

Le prédicteur de la figure 6 comprend essentiellement deux circuits de multiplication $M_1$ et $M_2$ recevant pour $M_1$ la grandeur xe (n) fournie à la sortie du circuit d'addition 10 et pour $M_2$ la grandeur xe (n—1) fournie à la sortie du registre $T_1$. Les grandeurs

obtenues en sortie des circuits de multiplication $M_1$ et $M_2$ respectivement par multiplication avec $a_1^*$ $(n+1)$ et $a_2^*$ $(n+1)$ sont additionnées au moyen du circuit d'addition 11 puis le résultat obtenu $x_{p(n+1)}$ est retardé au moyen de la ligne à retard 15 qui fournit l'échantillon $x_{pn}$ d'une part à l'entrée du circuit d'addition 2 et d'autre part à l'entrée du circuit d'addition 10. Une telle réalisation du prédicteur permet de calculer à l'avance $x_{pn}$ et de s'affranchir de ce fait des temps de calcul non négligeables dans les applications pratiques.

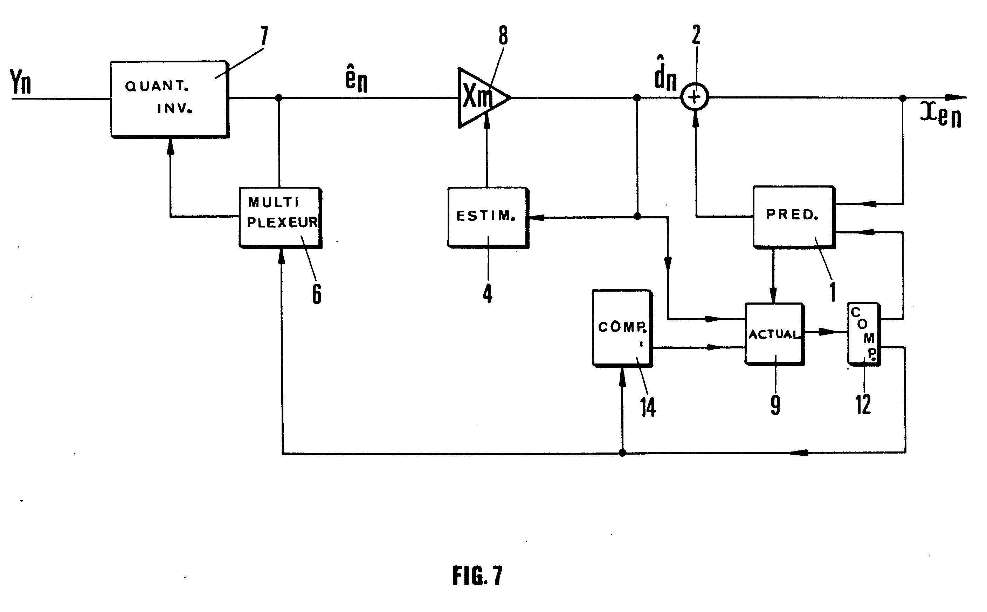

Le circuit d'addition 2 effectue la différence entre l'échantillon $x (n)$ reçu et l'échantillon prédit $x_{pn}$ fourni par le système de prédiction de l'invention et le résultat $d_n$ est multiplié par $1/m_{n-1}$ au moyen d'un circuit de multiplication 30, qui remplace le diviseur par m de la figure 2, le facteur $1/m_{n-1}$ étant fourni par la mémoire morte 31 ainsi que précédemment décrit. A la sortie du circuit 30 de multiplication on obtient une grandeur $e_n$ qui est transcodée au moyen du quantificateur 5. On obtient à la sortie du quantificateur 5 un signal $Y_n$ de débit binaire quatre bits par échantillon. Ce signal $Y_n$ est transmis en ligne et reçu au moyen d'un dispositif réception identique sans qu'il soit nécessaire de transmettre sur un canal parallèle les coefficients du prédicteur ou la grandeur m du taux de compression. Tous les paramètres sont calculés, en réception, à partir du signal $Y_n$ émis en ligne au moyen du dispositif réception tel que schématisé sur la figure 7.

Le signal $Y_n$ est reçu par le quantificateur inverse 7 qui est adressé par le dispositif 6 multiplexeur et fournit en sortie un signal $\hat{e}_n$. Ce signal $\hat{e}_n$ est appliqué à l'entrée d'un circuit 8 multiplicateur par m, m étant le taux de compression fourni par l'estimateur 4 de puissance moyenne. Le signal $\hat{d}_n$ obtenu à la sortie du dispositif 8 est appliqué d'une part à l'entrée de l'estimateur 4 et d'autre part à l'entrée du dispositif 9 permettant de calculer les coefficients en fonction des grandeurs $xe_{(n-1)}$ fournies par le prédicteur 1. Les coefficients $a_i (n)$ fournis par le dispositif 9 sont corrigés au moyen du dispositif comparateur 12 pour les maintenir à l'intérieur du domaine de stabilité. Ces coefficients bornés sont appliqués, d'une part, à l'entrée du dispositif multiplexeur 6 pour intervenir dans le choix de la courbe caractéristique de quantification et, d'autre part, à l'entrée du prédicteur 1.

Le prédicteur 1 fournit un signal prédit $x_{pn}$ à l'entrée du circuit d'addition 2, ce qui permet de reconstituer un échantillon $xe_n$ semblable à celui dont on disposait à l'émission. Cet échantillon $xe_n$ est appliqué à chaque instant à l'entrée du prédicteur 1 et intervient dans le calcul de l'échantillon suivant.

Un dispositif comparateur 14 permet, de la même façon qu'à l'émission, de calculer les coefficients $a_{oi}$ $(n)$ correspondant à l'absence de signal, à partir des coefficients $a_{oi}$ $(n+1)$ et $a_i (n)$.

Ces coefficients $a_{oi} (n)$ sont appliqués à l'entrée du dispositif 9.

Le dispositif réception permet donc bien de calculer, à partir du signal $Y_n$ émis en ligne, les paramètres, en l'absence d'erreurs de transmission, de la partie émission sans nécessiter l'envoi d'information sur un canal annexe, l'échantillon $xe_n$ étant identique, au bruit près, à $x_n$.

De plus l'étage prédicteur de l'invention protège le dispositif entier à réduction de redondance des erreurs de transmission ou même des erreurs de transcodage et lui confère un rôle aussi bien au niveau du choix de la caractéristique de quantification de l'étage de quantification, qu'un rôle de protection et de contrôle de l'évolution des coefficients eux-mêmes.

## Revendications

1. Dispositif pour réduire le débit numérique d'un signal MIC S formé d'échantillons $x_n$ de période T, comprenant trois étages montés en cascade, à savoir un premier étage dit de prédiction dans lequel on soustrait d'un échantillon $x_n$ un signal prédit $x_{pn}$ déduit des échantillons précédents pour former un signal de différence $d_n$, un second étage dit de compression automatique de gain dans lequel on divise l'amplitude du signal de différence $d_n$ pour obtenir un signal de différence divisé $e_n$, et un troisième étage dit quantificateur dans lequel on code le signal de différence divisé $e_n$ de façon à obtenir un signal de différence divisé et codé $Y_n$ de débit réduit par rapport au signal S, des moyens multiplicateurs et décodeurs étant prévus dans les second et troisième étages pour former un signal de différence $\hat{d}_n$ reconstitué à partir du signal de différence divisé et codé $Y_n$, le premier étage comprenant, pour la détermination des signaux prédits, un additionneur 10 recevant le signal prédit $X_{pn}$ et le signal $\hat{d}_n$, le signal de sortie de l'additionneur 10 étant appliqué à une série de multiplicateurs $M_1...M_N$ effectuant le produit par des coefficients respectifs $a_i (n)$ $(1 \leqslant i \leqslant N)$ déduits des échantillons n-i précédents selon un algorithme exploitant le critère du minimum de l'erreur quadratique, les multiplicateurs $M_2...M_N$ étant respectivement connectés à l'additionneur 10 par des lignes à retard $(T_2...T_N)$ imposant respectivement des retards 2T...NT, les produits obtenus à la sortie des multiplicateurs étant appliqués à un additionneur 11, une ligne à retard $T_1$ fournissant un retard T étant montée à la sortie de l'additionneur 10 ou en amont du multiplicateur $M_1$, le signal obtenu étant le signal prédit $x_{pn}$ qui sera retranché de l'échantillon $x_n$, caractérisé par le fait que l'étage quantificateur comprend des moyens de sélection (6) auxquels sont appliqués les coefficients $a_i (n)$ et comparant au moins un de ces coefficients à une valeur prédéterminée, pour déterminer les propriétés statistiques du signal S, et adapter ainsi le type de codage aux propriétés statistiques du signal S.

2. Dispositif selon la revendication 1, caractérisé par le fait que chaque coefficient $a_i (n)$ est obtenu en formant la somme du coefficient $a_i (n-1)$ calculé lors de la période précédente et du produit du signal respectivement appliqué au multiplicateur $M_i$ par le signal de différence $\hat{d}_n$ reconstitué et par une constante $\alpha$, en multipliant cette somme par une constante $1-\beta$ et en ajoutant au produit obtenu le produit du facteur $\beta$ par un coefficient $a_{oi} (n-1)$ choisi lors de la période précédente parmi une pluralité de valeurs en fonction de la statistique du signal entrant.

3. Dispositif selon la revendication 2, caractérisé par le fait que les coefficients $a_i$ sont, avant d'être appliqués, transformés en coefficients $a_i^*$ par un traitement consistant à comparer chaque coefficient avec les bords d'un domaine borné et à substituer à tout coefficient extérieur à ce domaine la valeur la plus proche sur la frontière du domaine.

**Patentansprüche**

1. Einrichtung zur Herabsetzung der Datenrate eines aus Proben $x_n$ einer Periode T gebildeten PCM-Signales S, mit drei hintereinander angeordneten Stufen, nämlich einer ersten Voraussagestufe, in welcher zur Bildung eines Differenzsignals $d_n$, von einer Probe $x_n$ ein von vorhergehenden Proben abgeleitetes Voraussagesignal $x_{pn}$ subtrahiert wird, einer zweiten Stufe zur antomatischen Verstärkungskompression, in welcher zur Erzeugung eines geteilten Differenzsignales $e_n$ die Amplitude des Differenzsignales $d_n$ geteilt wird, und einer dritten Quantisierstufe, in welcher das geteilte Differenzsignal $e_n$ derart codiert wird, dass ein geteiltes und codiertes Differenzsignal $Y_n$ mit einem mit Bezug auf das Signal S herabgesetzten Datenrate erhalten wird, mit in der zweiten und dritten Stufen vorgesehene Multiplizier- und Decodiereinrichtungen zur Bildung eines aus dem geteilten und codierten Differenzsignales $Y_n$ wiederhergestellten Differenzsignales $\hat{d}_n$, und wobei die erste Stufe zur Ermittlung von den Voraussagesignalen eine Addierschaltung 10 aufweist, an deren Eingang das Voraussagesignal $x_{pn}$ und das Signal $\hat{d}_n$ anliegt und dessen Ausgangssignale an mehrere Multiplizierschaltungen $M_1...M_N$ geführt sind, bei welchen die Produktbildung mit von den vorhergehenden Proben n-i gemäss einem durch das Kriterium des minimalen Fehlerquadrates bestimmten Algorithmus gebildeten Koeffizienten $a_i$ (n) $(1 \leqslant i \leqslant N)$ erfolgt, und wobei die Multiplizierschaltungen $M_2...M_N$ jeweils mit der Addierschaltung 10 über Verzögerungsleitungen $(T_2...T_N)$ einer jeweiligen Verzögerung von 2T...NT verbunden sind, die am Ausgang der Multiplizierschaltungen auftretenden Produkte an einer Addierschaltung 11 anliegen und eine Verzögerungsleitung $T_1$ mit einer Verzögerung T am Ausgang der Addierschaltung 10 oder im Sinne des Signalflusses vor der Multiplizierschaltung $M_1$ angeordnet ist, wobei das erhaltene Signal das Voraussagesignal $x_{pn}$ ist, das von der Probe $x_n$ abgezogen wird, dadurch gekennzeichnet, dass die Quantisierstufe eine mit den Koeffizienten $a_i$ (n) beaufschlagte Auswahleinrichtung (6) umfasst welche zur Bestimmung der statistischen Eigenschaften des Signals S und Anpassung der Art der Codierung an diese statistischen Eigenschaften des Signals S wenigstens einen dieser Koeffizienten mit einem vorgegebenen Wert vergleicht.

2. Einrichtung nach Anspruch 1, dadurch gekennzeichnet, dass jeder der Koeffizienten $a_i$ (n) dadurch erhalten wird, dass die Summe gebildet wird aus dem während der vorgängigen Periode errechneten Koeffizienten $a_i$ (n−1) und dem Produkt aus dem jeweils an der Multiplizierschaltung $M_i$ anliegenden Signal mit dem rekonstruierten Differenzsignal $\hat{d}_n$ sowie mit einer Konstante $\alpha$, diese Summe mit einer Konstanten 1-$\beta$ multipliziert wird und zu diesem Produkt das Produkt des Faktors $\beta$ mit einem Koeffizienten $a_{oi}$ (n−1) hinzugefügt wird, welcher Koeffizient $a_{oi}$ (n−1) während der vorgängigen Periode aus mehreren Werten in Abhängigkeit von der Statistik des Eingangssignals ausgewählt wird.

3. Einrichtung nach Anspruch 2, dadurch gekennzeichnet, dass die Koeffizienten $a_i$ bevor sie angelegt werden dadurch in Koeffizienten $a_i^*$ transformiert werden, dass jeder Koeffizient mit den Rändern eines begrenzten Bereiches verglichen und jeder ausserhalb dieses Bereiches liegende Koeffizient durch den an der Grenze des Bereiches am nächsten liegenden Wert ersetzt wird.

**Claims**

1. Device for reducing the digit rate of a PCM signal S formed by samples $x_n$ of period T, comprising three stages in cascade arrangement, namely a first so-called predictor stage in which a predicted sample $x_{pn}$ derived from the preceding samples is substracted from a sample $x_n$ to form a difference signal $d_n$, a second so-called automatic gain compression stage in which the amplitude of the difference signal $d_n$ is divided to obtain a divided difference signal $e_n$, and a third so-called quantizer stage in which the divided difference signal $e_n$ is encoded in order to obtain a divided and encoded difference signal $Y_n$ of reduced rate relative to the signal S, multiplier and encoder means being provided in the second and third stages to form a difference signal $\hat{d}_n$ reconstituted from the divided and encoded signal $Y_n$, the first stage comprising, for the determination of the predicted signals, an adder 10 receiving the predicted signal $x_{pn}$ and the signal $\hat{d}_n$, the output signal of the adder 10 being applied to a plurality of multipliers $M_1...M_N$ multiplying by respective coefficients $a_i$ (n) $(1 \leqslant i \leqslant N)$ derived from the n-i preceding samples according to algorithm carrying out the criterion of the minimum of the quadratic error, the multipliers $M_2...M_N$ being connected to the adder 10 respectively by delay lines $(T_2...T_N)$ providing respective delays 2T...NT, the produce obtained at the outputs of the multipliers being applied to an adder 11, a delay line $T_1$ providing a delay T being provided at the output of the adder 10 or upstream the multiplier $M_1$, the signal obtained being the predicted signal $x_{pn}$ which will substracted from the sample $x_n$, characterized in that the quantizer stage comprises selection means (6) to which the coefficient $a_i$ (n) are applied and comparing at least one of these coefficients with a predetermined value, to determine the statistical properties of the signal S, and thus adapting the type of encoding to the statistical properties of the signal S.

2. Device according to claim 1, characterized in that each coefficient $a_i$ (n) is obtained by forming the sum of the coefficient $a_i$ (n−1) computed during the preceding period and of the product of the signal respectively applied to the multiplier $M_i$ by the reconstituted difference signal $\hat{d}_n$ and by a constant $\alpha$, by multiplying sum by a constant 1-$\beta$ and by adding to the obtained product the product of the factor $\beta$ by a coefficient $a_{oi}$ (n−1) choosen during the preceding period among a plurality of values to the statistics of the incoming signal.

3. Device according to claim 2, characterized in that the coefficients $a_i$, before being applied, are transformed into coefficients $a_i^*$ by a processing consisting of comparing each coefficient to the edges of a limited domain and of substituting the closest value on the limit of the domain for any coefficient outside this domain.

**FIG.1**

Etage prédicteur          CAG          Etage quantificateur

FIG. 2

FIG. 3

**FIG. 4**

0 024 243

FIG. 5

FIG.6

**FIG. 7**

0 024 243